# EUROPEAN PATENT APPLICATION

(11) **EP 4 513 529 A2**
(43) Date of publication of application: **26.02.2025**
(21) Application number: 24315297.2
(22) Date of filing: 18.06.2024
(51) Int. Cl.: H01L 21/3213

(54) **SINGLE-MASK STACK ETCHING METHODS FOR FORMING STAIRCASE STRUCTURES**

(30) Priority: 27.06.2023 US 202318342200
(71) Applicant: STMicroelectronics International N.V., 1228 Plan-les-Ouates, Geneva (CH)
(72) Inventor: Ladroue, Julien, 37380 MONNAIE (FR); Boufnichel, Mohamed, 37380 MONNAIE (FR)
(74) Representative: Cabinet Beaumont

(57) **Abstract**

Methods, systems, and devices for semiconductor manufacturing are described. A stack of materials may be formed on a semiconductor substrate. The stack of materials may include a first material, a second material, and a third material. A first etching operation may be performed. The first etching operation may remove a first portion of the first material. A second etching operation may be performed. The second etching operation may remove a first portion of the second material. A third etching operation may be performed. The third etching operation may remove a first portion of the third material. A fourth etching operation may be performed: The fourth etching operation may remove a second portion of the second material. A fifth etching operation may be performed. The fifth etching operation may remove a second portion of the first material.

## Description

### FIELD OF THE INVENTION

Example embodiments of the present disclosure generally relate to semiconductor devices and fabrication techniques. More specifically, the present disclosure relates to single-mask stack etching methods for forming staircase structures.

### BACKGROUND

Some semiconductor devices may include layers of various materials formed in a stack above a semiconductor substrate. Such semiconductor devices may be formed using a variety of techniques, such as photolithography, etching, deposition, doping, and other techniques. Such techniques may be utilized to form the various materials into patterns and configurations that enable the operation of the semiconductor device. In some cases, a semiconductor device may include structures or materials that may be coupled with other devices, such as other semiconductor devices. For example, a semiconductor device may include one or more layers formed in such a way that the semiconductor device may be coupled with another semiconductor device (e.g., via soldering, via flip-chip bonding).

### BRIEF SUMMARY

Various embodiments described herein relate to methods, apparatuses, and systems associated with single-mask stack etching methods for forming staircase structures. A method according to an embodiment includes forming a stack of materials on a semiconductor substrate, the stack of materials including a first material, a second material, and a third material, performing a first etching operation, where the first etching operation removes a first portion of the first material, performing a second etching operation, where the second etching operation removes a first portion of the second material, performing a third etching operation, where the third etching operation removes a first portion of the third material, performing a fourth etching operation, where the fourth etching operation removes a second portion of the second material, and performing a fifth etching operation, where the fifth etching operation removes a second portion of the first material.

The method according to the embodiment may also include forming a fourth material on a surface of the first material, where a position of the fourth material is static for a duration of the first etching operation, the second etching operation, the third etching operation, the fourth etching operation, and the fifth etching operation. In some cases, removing the first portion of the first material exposes a portion of a bottom surface of a fourth material includes a photoresist layer, the portion of the bottom surface of the fourth material corresponding to an overhung region of the fourth material.

In some cases, removing the first portion of the second material exposes a portion of a bottom surface of the first material, the portion of the bottom surface of the first material corresponding to an overhung region of the first material. In some cases, removing the first portion of the third material exposes a portion of a bottom surface of the second material, the portion of the bottom surface of the second material corresponding to an overhung region of the second material. In some cases, removing the first portion of the first material, the first portion of the second material, and the first portion of the third material forms an inverted staircase structure in the stack of materials. In some cases, removing the second portion of the second material and removing the second portion of the first material forms a staircase structure in the stack of materials.

The method according to the embodiment may also include performing a rinsing operation subsequent to the first etching operation, the second etching operation, the third etching operation, the fourth etching operation, and the fifth etching operation. In some cases, each of the first etching operation, the second etching operation, the third etching operation, the fourth etching operation, and the fifth etching operation comprise an isotropic etching operation. In some cases, the first material includes silver, the second material includes nickel, and the third material includes titanium. Other technical features may be readily apparent to one skilled in the art from the following figures, descriptions, and claims.

In one aspect, an apparatus includes a first material of a stack of materials, the first material corresponding to a first step of a staircase structure formed using an isotropic etching operation, where a surface of the first step is parallel to an x-direction and a z-direction, and where a height of the first step is parallel to a y-direction, a second material of the stack of materials, the second material corresponding to a second step of the staircase structure, the second step of the staircase structure located below the first step of the staircase structure with respect to the y-direction, where an extent of the second step extends beyond an extent of the first step with respect to the x-direction, and a third material of the stack of materials, the third material corresponding to a third step of the staircase structure, the third step of the staircase structure located below the second step of the staircase structure with respect to the y-direction, where an extent of the third step extends beyond the extent of the second step with respect to the x-direction.

The apparatus may also include a semiconductor substrate corresponding to a fourth step of the staircase structure, the semiconductor substrate located below the third step of the staircase structure, where an extent of the fourth step extends beyond the extent of the third step with respect to the x-direction. In some cases, a height of the second step of the staircase structure is greater than a height of the third step of the staircase structure. In some cases, the first material includes silver, the second material includes nickel, and the third material includes titanium. Other technical features may be readily apparent to one skilled in the art from the following figures, descriptions, and claims.

In one aspect, a product may be formed by a method including forming a stack of materials on a semiconductor substrate, the stack of materials includes a first material, a second material, and a third material, performing a first etching operation, where the first etching operation removes a first portion of the first material, performing a second etching operation, where the second etching operation removes a first portion of the second material, performing a third etching operation, where the third etching operation removes a first portion of the third material, performing a fourth etching operation, where the fourth etching operation removes a second portion of the second material, and performing a fifth etching operation, where the fifth etching operation removes a second portion of the first material.

The method according to the embodiment may also include forming a fourth material on a surface of the first material, where a position of the fourth material is static for a duration of the first etching operation, the second etching operation, the third etching operation, the fourth etching operation, and the fifth etching operation. In some cases, removing the first portion of the first material exposes a portion of a bottom surface of a fourth material includes a photoresist layer, the portion of the bottom surface of the fourth material corresponding to an overhung region of the fourth material. In some cases, removing the first portion of the second material exposes a portion of a bottom surface of the first material, the portion of the bottom surface of the first material corresponding to an overhung region of the first material.

In some cases, removing the first portion of the third material exposes a portion of a bottom surface of the second material, the portion of the bottom surface of the second material corresponding to an overhung region of the second material. In some cases, removing the first portion of the first material, the first portion of the second material, and the first portion of the third material forms an inverted staircase structure in the stack of materials. In some cases, removing the second portion of the second material and removing the second portion of the first material forms a staircase structure in the stack of materials. The method according to the embodiment may also include performing a rinsing operation subsequent to the first etching operation, the second etching operation, the third etching operation, the fourth etching operation, and the fifth etching operation.

In some cases, each of the first etching operation, the second etching operation, the third etching operation, the fourth etching operation, and the fifth etching operation comprise an isotropic etching operation. In some cases, the first material includes silver, the second material includes nickel, and the third material includes titanium. Other technical features may be readily apparent to one skilled in the art from the following figures, descriptions, and claims. In some cases, removing the second portion of the first material includes removing at least the overhung region of the first material. In some cases, removing the second portion of the second material includes removing at least the overhung region of the second material. In some cases, removing the second portion of the first material includes removing at least the overhung region of the first material. In some cases, removing the second portion of the second material includes removing at least the overhung region of the second material. Other technical features may be readily apparent to one skilled in the art from the following figures, descriptions, and claims.

The foregoing illustrative summary, as well as other exemplary objectives and/or advantages of the disclosure, are further explained in the following detailed description and its accompanying drawings.

An embodiment provides a method comprising:
forming a stack of materials on a semiconductor substrate, the stack of materials comprising a first material, a second material, and a third material;
performing a first etching operation, wherein the first etching operation removes a first portion of the first material;
performing a second etching operation, wherein the second etching operation removes a first portion of the second material;
performing a third etching operation, wherein the third etching operation removes a first portion of the third material;
performing a fourth etching operation, wherein the fourth etching operation removes a second portion of the second material; and
performing a fifth etching operation, wherein the fifth etching operation removes a second portion of the first material.

According to an embodiment, the method further comprises:
forming a fourth material on a surface of the first material, wherein a position of the fourth material is static for a duration of the first etching operation, the second etching operation, the third etching operation, the fourth etching operation, and the fifth etching operation.

According to an embodiment, removing the first portion of the first material exposes a portion of a bottom surface of a fourth material comprising a photoresist layer, the portion of the bottom surface of the fourth material corresponding to an overhung region of the fourth material.

According to an embodiment, removing the first portion of the second material exposes a portion of a bottom surface of the first material, the portion of the bottom surface of the first material corresponding to an overhung region of the first material.

According to an embodiment, removing the second portion of the first material comprises removing at least the overhung region of the first material.

According to an embodiment, removing the first portion of the third material exposes a portion of a bottom surface of the second material, the portion of the bottom surface of the second material corresponding to an overhung region of the second material.

According to an embodiment, removing the second portion of the second material comprises removing at least the overhung region of the second material.

According to an embodiment, removing the first portion of the first material, the first portion of the second material, and the first portion of the third material forms an inverted staircase structure in the stack of materials.

According to an embodiment, removing the second portion of the second material and removing the second portion of the first material forms a staircase structure in the stack of materials.

According to an embodiment, the method further comprises:
performing a rinsing operation subsequent to the first etching operation, the second etching operation, the third etching operation, the fourth etching operation, and the fifth etching operation.

According to an embodiment, each of the first etching operation, the second etching operation, the third etching operation, the fourth etching operation, and the fifth etching operation comprise an isotropic etching operation.

An embodiment provides an apparatus comprising:
a first material of a stack of materials, the first material corresponding to a first step of a staircase structure formed using an isotropic etching operation, wherein a surface of the first step is parallel to an x-direction and a z-direction, and wherein a height of the first step is parallel to a y-direction;
a second material of the stack of materials, the second material corresponding to a second step of the staircase structure, the second step of the staircase structure located below the first step of the staircase structure with respect to the y-direction, wherein an extent of the second step extends beyond an extent of the first step with respect to the x-direction; and
a third material of the stack of materials, the third material corresponding to a third step of the staircase structure, the third step of the staircase structure located below the second step of the staircase structure with respect to the y-direction, wherein an extent of the third step extends beyond the extent of the second step with respect to the x-direction.

According to an embodiment, the apparatus further comprises:
a semiconductor substrate corresponding to a fourth step of the staircase structure, the semiconductor substrate located below the third step of the staircase structure, wherein an extent of the fourth step extends beyond the extent of the third step with respect to the x-direction.

According to an embodiment, a height of the second step of the staircase structure is greater than a height of the third step of the staircase structure.

According to an embodiment, the first material comprises silver, the second material comprises nickel, and the third material comprises titanium.

An embodiment provides a product formed by the method disclosed above.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates an example of a material arrangement that supports single-mask stack etching methods for forming staircase structures;
FIG. 2 illustrates examples of material arrangements that support single-mask stack etching methods for forming staircase structures;
FIG. 3 illustrates an example of a process flow that supports single-mask stack etching methods for forming staircase structures;
FIG. 4 illustrates an example of a process flow that supports single-mask stack etching methods for forming staircase structures; and
FIGs. 5-6 illustrate examples of flowcharts that support single-mask stack etching methods for forming staircase structures.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

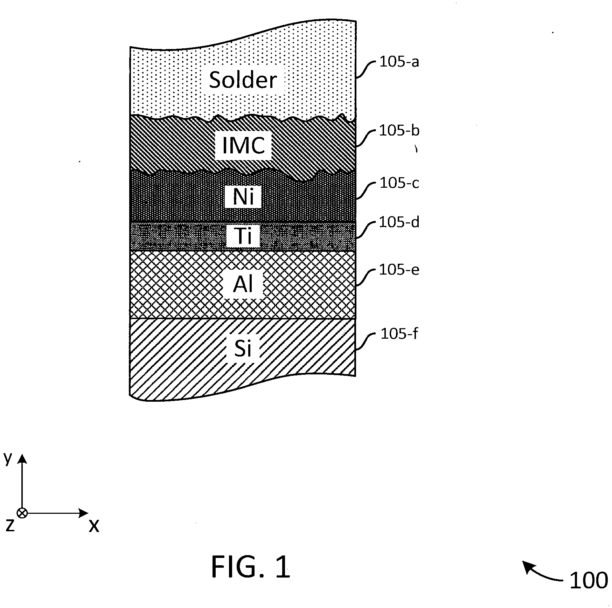

**FIG.** 1 illustrates an example of a material arrangement 100 that supports single-mask stack etching methods for forming staircase structures, in some examples. In some cases, the material arrangement 100 may be an example of a portion of semiconductor device or any other electronic device. The material arrangement 100 may be a device or a portion of a device employed in a variety of applications such as automotive applications (e.g., for motor control, for a charging module). The material arrangement 100 may illustrate a section view of a semiconductor device where some portions of the semiconductor device may be truncated or not shown. The material arrangement 100 may include one or more layers 105, which may each correspond to one or more different materials. Although some examples of specific materials or material compounds are described herein, the material arrangement 100 may include any combination of materials and material compounds. The material arrangement 100 may be oriented or otherwise formed with respect to a coordinate system, as shown in FIG. 1. For example, each layer 105 may have a width parallel to an x-direction, a depth (e.g., into the page) parallel to a z-direction, and a height parallel to a y-direction.

In one illustrative example the material arrangement 100 may include six layers 105, although any quantity of layers 105 may be used. For example, the layer 105-e may be omitted from the material arrangement 100, or other layers 105 may be added, such as a silver layer. The material arrangement 100 may include a layer 105-a (e.g., a solder layer), a layer 105-b (e.g., an intermetallic compound (IMC) layer), a layer 105-c (e.g., a nickel layer), a layer 105-d (e.g., a titanium layer), a layer 105-e (e.g., an aluminum layer), and a layer 105-f (e.g., a silicon layer). Each layer 105 may be formed in contact with one or more other layers 105. In some cases, the layer 105-f may be an example of a semiconductor substrate, which other layers 105 may be formed on top of. For example, the layer 105-e may be formed on top of the layer 105-f. In some cases, one or more layers 105 may be formed as part of a metallization operation (e.g., final metallization may be performed using TiNiAg).

In some cases, the material arrangement 100 may be formed using one or more operations, such as lithography, etching, deposition, doping, metallization, soldering, or any other type of operation. In some cases, the layer 105-e may be deposited on the layer 105-f, the layer 105-d may be deposited on the layer 105-e, and the layer 105-c may be deposited on the layer 105-d. Although not shown, an additional layer 105 (e.g., a silver layer) may be deposited on the layer 105-c and melted during a soldering operation. That is, the additional layer 105 may be an example of one or more constituents of the layer 105-b. As described herein, the material arrangement 100 may illustrate a stack of materials including one or more layers 105 that have undergone a soldering operation or any other type of operation that results in the formation of the layer 105-b (e.g., a IMC layer). The layer 105-b may be an example of a compound or a mixture of one or more materials. For example, the layer 105-b may include solder, silver, nickel, or any other combination of materials.

In some cases, the material arrangement 100 may include one or more layers 105 for coupling the layer 105-f (e.g., the semiconductor substrate) or the layer 105-e (e.g., a redistribution layer) with circuitry of one or more other devices, such as another semiconductor device (not shown). For example, the layer 105-d, the layer 105-c, and at least a portion of the layer 105-b may an example of an under-bump metallization (UBM), which may refer to a conductive portion of a semiconductor device located below a solder bump (e.g., the layer 105-a). In such cases, the material arrangement 100 may be one example of a plurality of material arrangements 100 of a semiconductor device.

In some cases, a thickness (e.g., with respect to the y-direction) of one or more layers 105 may be relatively large when compared to other layers 105 (e.g., due to soldering reflow constraints). For example, the layer 105-c may be up to 2 microns (µm) thick and the layer 105-d may be up to 200 nanometers (nm) thick. However, increasing a thickness of the layer 105-c may present one or more challenges. For example, the material arrangement 100 may undergo one or more etching operations, which may create various mechanical instabilities exacerbated by thickness differences between layers 105.

In accordance with one or more examples as described herein, a staircase structure (e.g., a staircase pattern, a pyramid structure) may be formed in the material arrangement 100, which may, in some examples, improve the mechanical stability of the material arrangement 100. The staircase structure may be formed using one or more etching operations (e.g., one or more spray wet etching operations, one or more isotropic etching operations), which may be associated with relatively lower costs when compared to other types of etching operations (e.g., anisotropic etching operations, dry etching operations). The techniques described herein may utilize a single mask (e.g., a single resist layer), which may provide advantages when compared to other techniques that require multiple masks or mask realignment for each etching operation (e.g., for each material). The techniques described herein may include first forming an inverted staircase structure and then performing one or more pullback operations (e.g., one or more additional etching operations) to reverse a directionality of the inverted staircase structure (e.g., to form the staircase structure). For example, silver, nickel, and titanium layers may be etched sequentially, forming an inverted staircase structure, and then nickel and silver layers may be pulled back (e.g., using respective etching operations) to form a staircase structure. The single-mask stack etching process may also include performing rinsing operations after each respective etching operation and performing a final drying operation.

As described herein, the material arrangement 100 may be an example of a power device or a portion of a power device. For example, the material arrangement 100 may be an example of a transistor (e.g., a power transistor) or a diode (e.g., a power diode). Such power devices may be capable of handling relatively high currents and relatively high voltages when compared to other devices. In some cases, the material arrangement 100 may be an example of a power device (e.g., a transistor, a diode) included in a charging module for an electric vehicle. Additionally, or alternatively, the material arrangement 100 may be an example of a power device (e.g., a transistor, a diode) included in a motor control module for an electric vehicle. In some cases, the material arrangement 100 may be an example of a bipolar junction transistor (BJT), a field effect transistor (FET), a metal-oxide-semiconductor field-effect transistor (MOSFET), an insulated gate bipolar transistor (IGBT), a thyristor, or a silicon-controlled rectifier (SCR).

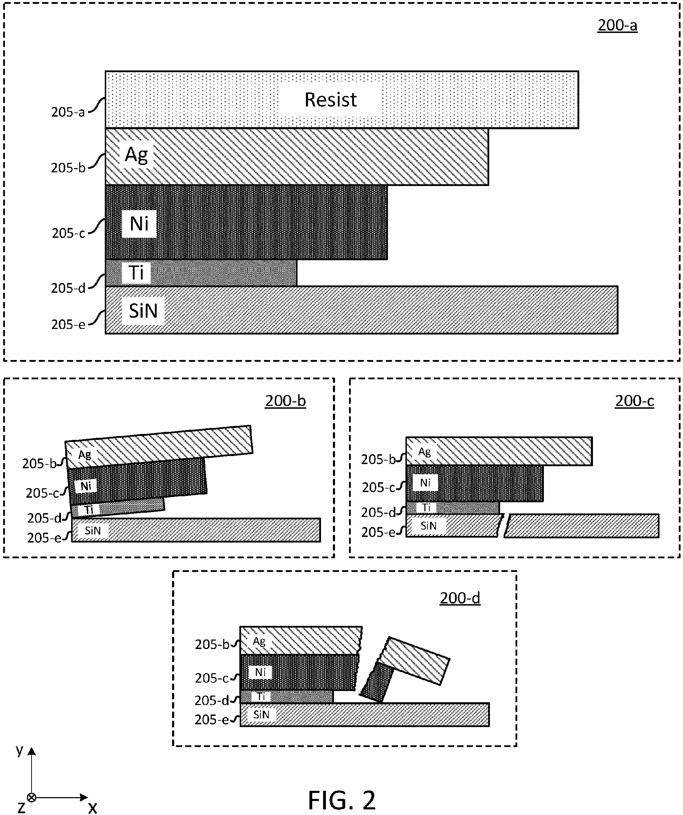

**FIG. 2** illustrates examples of material arrangements 200 that support single-mask stack etching methods for forming staircase structures. As described herein, an inverted staircase structure may be formed in material arrangements 200 (e.g., using one or more etching operations). In some cases, the inverted staircase structure may give rise to one or more types of instabilities such as delamination, fracturing, or any other type of instability, some of which may be illustrated by the material arrangement 200-b, the material arrangement 200-c, or the material arrangement 200-d. Such instabilities may, in some cases, be caused by or exacerbated by a layer 205-c (e.g., a nitride layer), which may be larger or thicker than other layers 205 and may accordingly have a greater weight than other layers 205. In accordance with examples described herein, one or more etching operations may be performed to eliminate overhang regions associated with the inverted staircase structure, which may improve the mechanical strength and performance of a material arrangement 200. The material arrangements 200 may each be oriented or otherwise formed with respect to a coordinate system, as shown in FIG. 2. For example, each layer 205 may have a width parallel to an x-direction, a depth (e.g., into the page) parallel to a z-direction, and a height parallel to a y-direction.

A material arrangement 200 may include any quantity of layers 205, which may be formed using different materials. For example, the material arrangement 200-a may include a layer 205-a (e.g., a photoresist layer), a layer 205-b (e.g., a silver layer), a layer 205-c (e.g., a nickel layer), a layer 205-d (e.g., a titanium layer), and a layer 205-e (e.g., a silicon nitride layer). Each layer 205 may be formed in contact with one or more other layers 205. In some cases, the layer 205-e may be an example of a semiconductor substrate, which other layers 205 may be formed on top of. The material arrangement 200-a, the material arrangement 200-b, the material arrangement 200-c, and the material arrangement 200-d may include one or more of the same layers 205 and may illustrate a same material arrangement 200 at different steps of a manufacturing process. For example, the material arrangement 200-b, the material arrangement 200-c, and the material arrangement 200-d may illustrate the material arrangement 200-a after the layer 205-a has been removed.

Each material arrangement 200 may be an example of a portion of semiconductor device or any other electronic device. For example, a material arrangement 200 may illustrate an edge region of a semiconductor device where an inverted staircase structure is formed using one or more manufacturing operations, such as one or more etching operations. As described herein, the phrase "inverted staircase structure" may refer to a region of a material arrangement 200 where a portion of each layer 205 overhangs a region of empty space (e.g., a portion of each layer 205 is not supported by or in contact with a layer 205 below). For example, an edge or extent of the layer 205-a with respect to the x-direction may extend beyond an edge or extent of the layer 205-b, an edge or extent of the layer 205-b with respect to the x-direction may extend beyond an edge or extend of the layer 205-c, and so forth.

In some cases, the material arrangements 200 may be formed using one or more operations, such as lithography, etching, deposition, doping, metallization, soldering, or any other type of operation. In some cases, the layer 205-d may be deposited on the layer 205-e, the layer 205-c may be deposited on the layer 205-d, the layer 205-b may be deposited on the layer 205-c, and the layer 205-a may be deposited on the layer 205-b. Although not shown, an additional layer (e.g., an aluminum layer) may be deposited on the layer 205-e. As described herein, the material arrangement 200 may illustrate a stack of materials including one or more layers 205 that have undergone one or more etching operations (e.g., one or more isotropic etching operations), resulting in the formation of an inverted staircase structure.

In some cases, various types of mechanical instabilities may result in failure of a material arrangement 200. Such mechanical instabilities may be caused by uneven weight distribution associated with the layer 205-c, or more generally by uneven weight distribution associated with overhung regions. That is, the inverted staircase structure itself may be prone to some types of mechanical instabilities. The material arrangement 200-b illustrates an example of delamination between the layer 205-d and the layer 205-e. The material arrangement 200-c illustrates an example of cracking or fracturing that may occur in the layer 205-e. The material arrangement 200-d illustrates an example of cracking or fracturing that may occur in the layer 205-b and the layer 205-c.

In accordance with one or more examples as described herein, a staircase structure (e.g., a staircase pattern, a pyramid structure) may be formed in a material arrangement 200, which may improve the mechanical stability of the material arrangement 200. For example, the staircase structure may eliminate overhung regions in a material arrangement 200, which may improve mechanical stability. Additionally, eliminating overhung regions in the material arrangement 200 may enable one or more critical dimensions to be viewed when inspecting the material arrangement 200 from above. For example, an extent of each step in the staircase structure may be visible from above, which may enable some in-process inspections and accordingly improve efficiency associated with manufacturing.

The staircase structure may be formed using one or more etching operations (e.g., one or more wet etching operations, one or more isotropic etching operations), which may be associated with relatively lower costs when compared to other types of etching operations (e.g., anisotropic etching operations). The techniques described herein may utilize a single mask, which may be formed using a single layer 205-a (e.g., a single resist layer). As described herein, using a single mask for forming the staircase structure may provide advantages when compared to other techniques that require multiple masks or mask realignment for each etching operation (e.g., for each material). Such techniques may include first forming an inverted staircase structure and then performing one or more pullback operations (e.g., one or more additional etching operations) to reverse a directionality of the inverted staircase structure (e.g., to form the staircase structure). For example, a layer 205-b, a layer 205-c, and a layer 205-d may be etched sequentially, forming an inverted staircase structure, and then the layer 205-c and the layer 205-d may be pulled back (e.g., using respective etching operations) to form a staircase structure. The single-mask stack etching process may also include performing rinsing operations after each respective etching operation and performing a final drying operation.

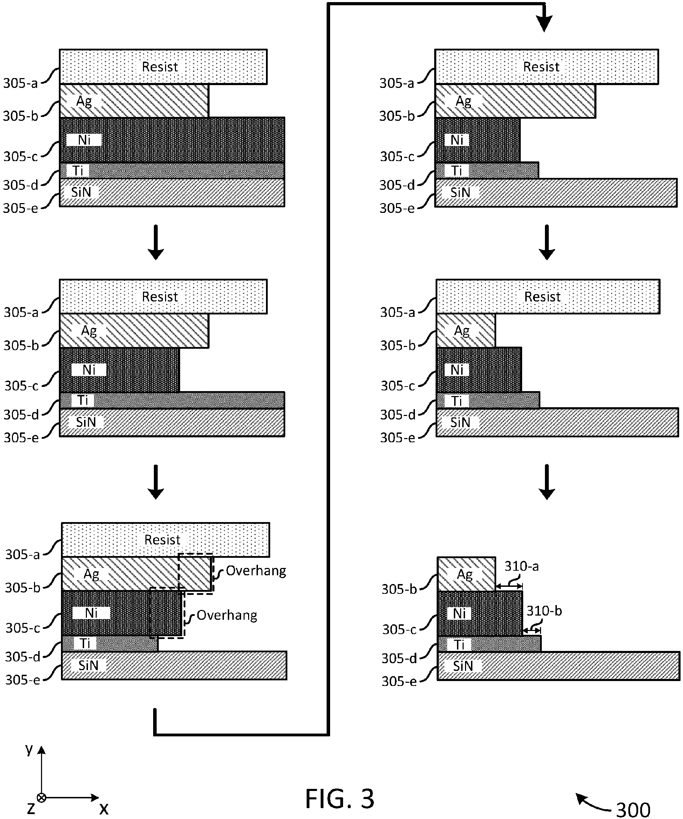

**FIG. 3** illustrates an example of a process flow 300 that supports single-mask stack etching methods for forming staircase structures. The process flow 300 may illustrate one or more aspects of a material arrangement 100 or a material arrangement 200 during a manufacturing operation. The process flow 300 may illustrate one or more layers 305, which may be examples of layers 105 or layers 205, as described with reference to FIG. 1 and FIG. 2, respectively. A final step of the process flow 300 may illustrate an example of a staircase structure. For example, the execution of the process flow 300 may result in the formation of a staircase structure including the layer 305-b (e.g., a first step), the layer 305-c (e.g., a first step), the layer 305-d (e.g., a first step), and the layer 305-e (e.g., a first step). In one illustrative example, the layer 305-a may be formed of a material that is resistant to ultraviolet light, the layer 305-b may be formed of silver, the layer 305-c may be formed of nickel, the layer 305-d may be formed of titanium, and the layer 305-e may be formed of silicon nitride. However, any other combination of materials may be used. For example, an aluminum layer may be added between the layer 305-e and the layer 305-d. The layers 305 may be oriented or otherwise formed with respect to a coordinate system, as shown in FIG. 3. For example, each layer 305 may have a width parallel to an x-direction, a depth (e.g., into the page) parallel to a z-direction, and a height parallel to a y-direction.

During a first phase (e.g., a first step) of a manufacturing operation, a first etching operation (e.g., a wet etching operation, an isotropic etching operation) may be performed to remove a first portion of the layer 305-b. The first portion of the layer 305-b may be at least partially underneath the layer 305-a. For example, removing the first portion of the layer 305-b may result in the formation of an overhang (e.g., a portion of the layer 305-a may overhang a region where the first portion of the layer 305-b has been removed). In some cases, the first etching operation may include depositing a first etching solution that selectively etches a specific material (e.g., silver). A single mask (e.g., the layer 305-a) may be utilized as a guide for the first etching solution. For example, a quantity of material removed from the layer 305-b may be based on the single mask (e.g., the position or size of the single mask) and a duration of time that the etching solution is exposed to the layer 305-b. In some cases, a first rinsing operation may be performed subsequent to the first etching operation. The first rinsing operation may remove contaminants, residues, or other materials.

During a second phase (e.g., a second step) of the manufacturing operation, a second etching operation (e.g., a wet etching operation, an isotropic etching operation) may be performed to remove a first portion of the layer 305-c. The first portion of the layer 305-c may be at least partially underneath the layer 305-b. For example, removing the first portion of the layer 305-c may result in the formation of an overhang (e.g., a portion of the layer 305-b may overhang a region where the first portion of the layer 305-c has been removed). In some cases, the second etching operation may include depositing a second etching solution that selectively etches a specific material (e.g., nickel). A single mask (e.g., the layer 305-a) may be utilized as a guide for the second etching solution. Additionally, or alternatively, the single mask may remain stationary (e.g., may not be repositioned) for a duration of the first etching operation and the second etching operation. In some cases, a second rinsing operation may be performed subsequent to the second etching operation. The second rinsing operation may remove contaminants, residues, or other materials.

During a third phase (e.g., a third step) of the manufacturing operation, a third etching operation (e.g., a wet etching operation, an isotropic etching operation) may be performed to remove a first portion of the layer 305-d. The first portion of the layer 305-d may be at least partially underneath the layer 305-c. For example, removing the first portion of the layer 305-c may result in the formation of an overhang (e.g., a portion of the layer 305-c may overhang a region where the first portion of the layer 305-d has been removed). In some cases, the third etching operation may include depositing a third etching solution that selectively etches a specific material (e.g., titanium). A single mask (e.g., the layer 305-a) may be utilized as a guide for the third etching solution. Additionally, or alternatively, the single mask may remain stationary (e.g., may not be repositioned) for a duration of the first etching operation, the second etching operation, and the third etching operation. In some cases, a third rinsing operation may be performed subsequent to the third etching operation. The third rinsing operation may remove contaminants, residues, or other materials.

During a fourth phase (e.g., a fourth step) of the manufacturing operation (e.g., a pullback step), a fourth etching operation (e.g., a wet etching operation, an isotropic etching operation) may be performed to remove a second portion of the layer 305-c. The second portion of the layer 305-c may include at least an overhang portion of the layer 305-c. For example, removing the second portion of the layer 305-c may result in the elimination of an overhang. In some cases, the fourth etching operation may include depositing the second etching solution that selectively etches a specific material (e.g., nickel). A single mask (e.g., the layer 305-a) may be utilized as a guide for the second etching solution. Additionally, or alternatively, the single mask may remain stationary (e.g., may not be repositioned) for a duration of the first etching operation, the second etching operation, the third etching operation, and the fourth etching operation. In some cases, a fourth rinsing operation may be performed subsequent to the fourth etching operation. The fourth rinsing operation may remove contaminants, residues, or other materials.

During a fifth phase (e.g., a fifth step) of the manufacturing operation (e.g., a pullback step), a fifth etching operation (e.g., a wet etching operation, an isotropic etching operation) may be performed to remove a second portion of the layer 305-b. The second portion of the layer 305-b may include at least an overhang portion of the layer 305-b. For example, removing the second portion of the layer 305-b may result in the elimination of an overhang. In some cases, the fifth etching operation may include depositing the first etching solution that selectively etches a specific material (e.g., silver). A single mask (e.g., the layer 305-a) may be utilized as a guide for the first etching solution. Additionally, or alternatively, the single mask may remain stationary (e.g., may not be repositioned) for a duration of the first etching operation, the second etching operation, the third etching operation, the fourth etching operation, and the fifth etching operation. In some cases, a fifth rinsing operation may be performed subsequent to the fifth etching operation. The fifth rinsing operation may remove contaminants, residues, or other materials. In some cases, a drying operation may be performed subsequent to the fifth rinsing operation and the layer 305-a may be removed.

Subsequent to the completion of the fifth phase of the manufacturing operation, a staircase structure may be formed in the layers 305. For example, a surface of the layer 305-c may be exposed. The exposed surface of the layer 305-c may have a dimension 310-a. In some cases, the dimension 310-a may be between 10 nm and 10 µm. Additionally, a surface of the layer 305-d may be exposed. The exposed surface of the layer 305-d may have a dimension 310-b. In some cases, the dimension 310-b may be between 10 nm and 2 µm. In one example, the dimension 310-b may be less than the dimension 310-a. Additionally, each layer 305 may have a respective height along the y-direction. In some examples, a height of the layer 305-c may be greater than a height of the layer 305-b and a height of the layer 305-d. For example, the height of the layer 305-c may be between 250 nm and 2 µm.

As described herein, the staircase structure (e.g., formed in the material arrangement 100, formed in the material arrangement 200) may be an example of a power device or a portion of a power device. For example, the staircase structure may be an example of a transistor (e.g., a power transistor) or a diode (e.g., a power diode). Such power devices may be capable of handling relatively high currents and relatively high voltages when compared to other devices. In some cases, the staircase structure may be an example of a power device (e.g., a transistor, a diode) included in a charging module for an electric vehicle. Additionally, or alternatively, the staircase structure may be an example of a power device (e.g., a transistor, a diode) included in a motor control module for an electric vehicle. In some cases, the staircase structure may be an example of a BJT, an FET, a MOSFET, an IGBT, a thyristor, or an SCR.

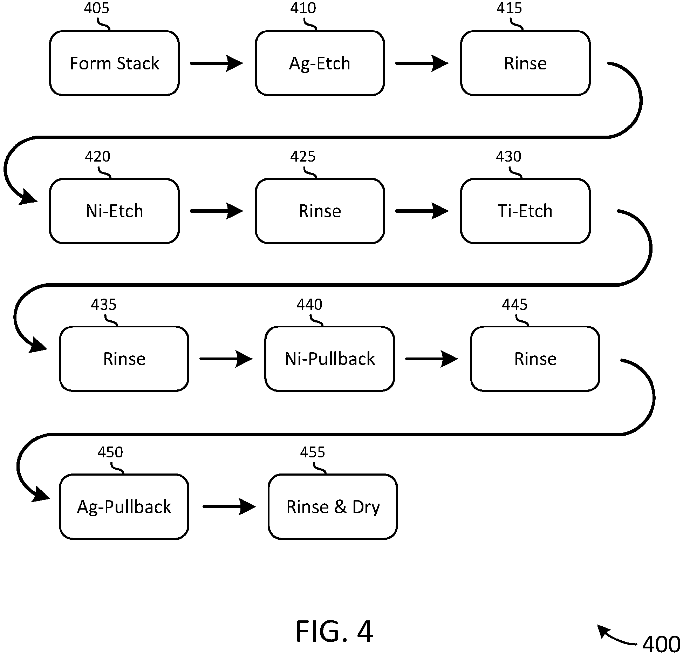

**FIG. 4** illustrates an example of a process flow 400 that supports single-mask stack etching methods for forming staircase structures. The process flow 400 may include a quantity of steps for forming a semiconductor device. In some cases, the steps included in the process flow 400 may be performed in a single photolithography level (e.g., using a single photoresist). The process flow 400 may be performed by one or more devices or machines specifically designed for semiconductor manufacturing. For example, one or more steps in the process flow 400 may be performed by a machine configured to perform wet etching operations. In some cases, the steps of the process flow 400 may include one or more steps that are not shown. For example, one or more interface oxidation management operations may be performed, in some examples, to avoid residues and filaments. Additionally, or alternatively, one or more steps may be omitted from the process flow 400.

At 405, a stack of materials may be formed on a semiconductor substrate. The stack of materials may include a first material (e.g., silver), a second material (e.g., nickel), and a third material (e.g., titanium). Although some illustrative examples are described with reference to titanium, nickel, and silver, any combination of materials (e.g., any metals suitable for brazing) may be used. For example, the operations described herein may be performed for any combination of titanium, nickel, copper, silver, and gold. In some cases (e.g., at 405 or prior to 405), a fourth material may be formed on a surface of the first material. The fourth material may be a photoresist material or a masking material. In some cases, a position of the fourth material may be static for a duration of a first etching operation, a second etching operation, a third etching operation, a fourth etching operation and a fifth etching operation.

At 410, the first etching operation may be performed. The first etching operation may be a wet etching operation and may cause isotropic material removal. The first etching operation may remove a first portion of the first material. In some cases, removing the first portion of the first material exposes a portion of a bottom surface of the fourth material (e.g., the masking material). The portion of the bottom surface of the fourth material may correspond to an overhung region of the fourth material. At 415, a rinsing operation may be performed.

At 420, the second etching operation may be performed. The second etching operation may a be a wet etching operation and may cause isotropic material removal. The second etching operation may remove a first portion of the second material. In some cases, removing the first portion of the second material may expose a portion of a bottom surface of the first material. The portion of the bottom surface of the first material may correspond to an overhung region of the first material. At 425, a rising operation may be performed.

At 430, the third etching operation may be performed. The third etching operation may a be a wet etching operation and may cause isotropic material removal. The third etching operation may remove a first portion of the third material. In some cases, removing the first portion of the third material may expose a portion of a bottom surface of the second material. The portion of the bottom surface of the second material may correspond to an overhung region of the second material. In some cases, removing the first portion of the first material, the first portion of the second material, and the first portion of the third material may form an inverted staircase structure in the stack of materials. At 435, a rising operation may be performed.

At 440, the fourth etching operation may be performed. The fourth etching operation may a be a wet etching operation and may cause isotropic material removal. The fourth etching operation may remove a second portion of the second material. In some cases, removing the second portion of the second material may include removing at least the overhung region of the second material. At 445, a rinsing operation may be performed.

At 450, the fifth etching operation may be performed. The fifth etching operation may a be a wet etching operation and may cause isotropic material removal. The fifth etching operation may remove a second portion of the first material. In some cases, removing the second portion of the first material may include removing at least the overhung region of the first material. In some cases, removing the second portion of the second material and removing the second portion of the first material may form a staircase structure in the stack of materials. At 455, a rinsing operation may be performed and a drying operation may be performed subsequent to the rinsing operation.

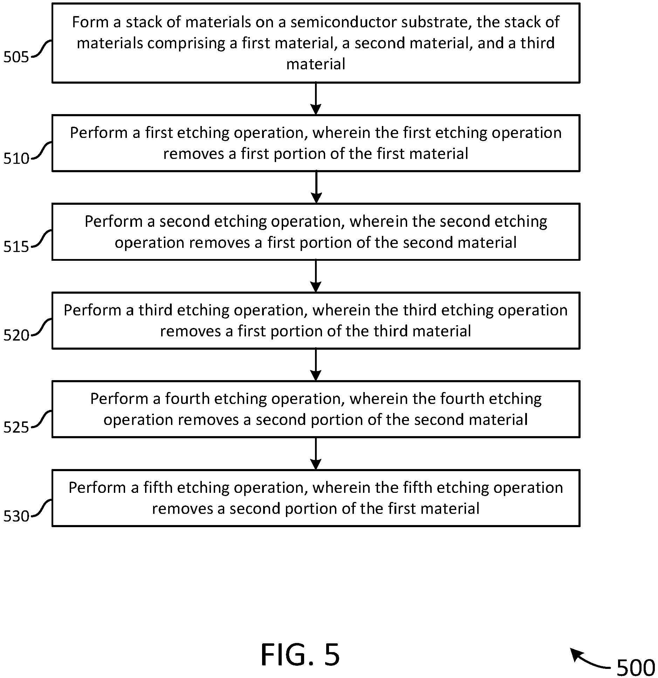

**FIG. 5** illustrates an example of a flowchart illustrating a method 500 that supports single-mask stack etching methods for forming staircase structures. The operations of the method 500 may be implemented by a manufacturing system or a machine configured for performing one or more operations as described herein. For example, a machine or manufacturing system configured to perform one or more etching operations may perform the operations of the method 500. In some cases, a manufacturing system or machine may execute instructions to control one or more functional elements to perform the described operations. Additionally, or alternatively, a machine or manufacturing system may perform aspects of the described operations using special-purpose hardware.

At 505, the method 500 may include forming a stack of materials on a semiconductor substrate. The stack of materials may include a first material, a second material, and a third material. The operations may be performed in accordance with examples as described herein. In some examples, aspects of the operations may be performed using a special-purpose machine or manufacturing system.

At 510, the method 500 may include performing a first etching operation. The first etching operation may remove a first portion of the first material. The operations may be performed in accordance with examples as described herein. In some examples, aspects of the operations may be performed using a special-purpose machine or manufacturing system.

At 515, the method 500 may include performing a second etching operation. In some cases, the second etching operation may remove a first portion of the second material. The operations may be performed in accordance with examples as described herein. In some examples, aspects of the operations may be performed using a special-purpose machine or manufacturing system.

At 520, the method 500 may include performing a third etching operation. The third etching operation may remove a first portion of the third material. The operations may be performed in accordance with examples as described herein. In some examples, aspects of the operations may be performed using a special-purpose machine or manufacturing system.

At 525, the method 500 may include performing a fourth etching operation. The fourth etching operation may remove a second portion of the second material. The operations may be performed in accordance with examples as described herein. In some examples, aspects of the operations may be performed using a special-purpose machine or manufacturing system.

At 530, the method 500 may include performing a fifth etching operation. The fifth etching operation may remove a second portion of the first material. The operations may be performed in accordance with examples as described herein. In some examples, aspects of the operations may be performed using a special-purpose machine or manufacturing system.

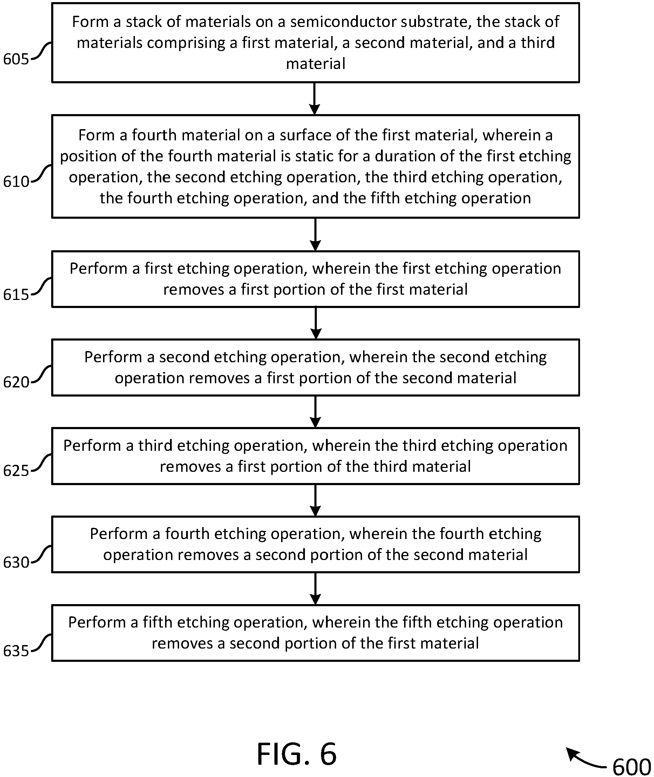

**FIG. 6** illustrates an example of a flowchart illustrating a method 600 that supports single-mask stack etching methods for forming staircase structures. The operations of the method 600 may be implemented by a manufacturing system or a machine configured for performing one or more operations as described herein. For example, a machine or manufacturing system configured to perform one or more etching operations may perform the operations of the method 600. In some cases, a manufacturing system or machine may execute instructions to control one or more functional elements to perform the described operations. Additionally, or alternatively, a machine or manufacturing system may perform aspects of the described operations using special-purpose hardware.

At 605, the method 600 may include forming a stack of materials on a semiconductor substrate. The stack of materials may include a first material, a second material, and a third material. The operations may be performed in accordance with examples as described herein. In some examples, aspects of the operations may be performed using a special-purpose machine or manufacturing system.

At 610, the method 600 may include forming a fourth material on a surface of the first material. The position of the fourth material maya be static for a duration of the first etching operation, the second etching operation, the third etching operation, the fourth etching operation, and the fifth etching operation. The operations may be performed in accordance with examples as described herein. In some examples, aspects of the operations may be performed using a special-purpose machine or manufacturing system.

At 615, the method 600 may include performing a first etching operation. The first etching operation may remove a first portion of the first material. The operations may be performed in accordance with examples as described herein. In some examples, aspects of the operations may be performed using a special-purpose machine or manufacturing system.

At 620, the method 600 may include performing a second etching operation. In some cases, the second etching operation may remove a first portion of the second material. The operations may be performed in accordance with examples as described herein. In some examples, aspects of the operations may be performed using a special-purpose machine or manufacturing system.

At 625, the method 600 may include performing a third etching operation. The third etching operation may remove a first portion of the third material. The operations may be performed in accordance with examples as described herein. In some examples, aspects of the operations may be performed using a special:purpose machine or manufacturing system.

At 630, the method 600 may include performing a fourth etching operation. The fourth etching operation may remove a second portion of the second material. The operations may be performed in accordance with examples as described herein. In some examples, aspects of the operations may be performed using a special-purpose machine or manufacturing system.

At 635, the method 600 may include performing a fifth etching operation. The fifth etching operation may remove a second portion of the first material. The operations may be performed in accordance with examples as described herein. In some examples, aspects of the operations may be performed using a special-purpose machine or manufacturing system.

The disclosed embodiments can be summarized with the following examples.

Example 1: A method comprising:
forming a stack of materials on a semiconductor substrate, the stack of materials comprising a first material, a second material, and a third material;
performing a first etching operation, wherein the first etching operation removes a first portion of the first material;
performing a second etching operation, wherein the second etching operation removes a first portion of the second material;
performing a third etching operation, wherein the third etching operation removes a first portion of the third material;
performing a fourth etching operation, wherein the fourth etching operation removes a second portion of the second material; and
performing a fifth etching operation, wherein the fifth etching operation removes a second portion of the first material.

Example 2: The method of example 1, further comprising:
forming a fourth material on a surface of the first material, wherein a position of the fourth material is static for a duration of the first etching operation, the second etching operation, the third etching operation, the fourth etching operation, and the fifth etching operation.

Example 3: The method of example 1 or 2, wherein removing the first portion of the first material exposes a portion of a bottom surface of a fourth material comprising a photoresist layer, the portion of the bottom surface of the fourth material corresponding to an overhung region of the fourth material.

Example 4: The method of any of examples 1 to 3, wherein removing the first portion of the second material exposes a portion of a bottom surface of the first material, the portion of the bottom surface of the first material corresponding to an overhung region of the first material.

Example 5: The method of example 4, wherein removing the second portion of the first material comprises removing at least the overhung region of the first material.

Example 6: The method of any of examples 1 to 5, wherein removing the first portion of the third material exposes a portion of a bottom surface of the second material, the portion of the bottom surface of the second material corresponding to an overhung region of the second material.

Example 7: The method of example 6, wherein removing the second portion of the second material comprises removing at least the overhung region of the second material.

Example 8: The method of any of examples 1 to 7, wherein removing the first portion of the first material, the first portion of the second material, and the first portion of the third material forms an inverted staircase structure in the stack of materials.

Example 9: The method of any of example 1 to 8, wherein removing the second portion of the second material and removing the second portion of the first material forms a staircase structure in the stack of materials.

Example 10: The method of any of examples 1 to 9, further comprising:
performing a rinsing operation subsequent to the first etching operation, the second etching operation, the third etching operation, the fourth etching operation, and the fifth etching operation.

Example 11: The method of any of examples 1 to 10, wherein each of the first etching operation, the second etching operation, the third etching operation, the fourth etching operation, and the fifth etching operation comprise an isotropic etching operation.

Example 12: The method of any of examples 1 to 11, wherein the first material comprises silver, the second material comprises nickel, and the third material comprises titanium

Example 13 An apparatus comprising:
a first material of a stack of materials, the first material corresponding to a first step of a staircase structure formed using an isotropic etching operation, wherein a surface of the first step is parallel to an x-direction and a z-direction, and wherein a height of the first step is parallel to a y-direction;
a second material of the stack of materials, the second material corresponding to a second step of the staircase structure, the second step of the staircase structure located below the first step of the staircase structure with respect to the y-direction, wherein an extent of the second step extends beyond an extent of the first step with respect to the x-direction; and
a third material of the stack of materials, the third material corresponding to a third step of the staircase structure, the third step of the staircase structure located below the second step of the staircase structure with respect to the y-direction, wherein an extent of the third step extends beyond the extent of the second step with respect to the x-direction.

Example 14: The apparatus of example 13, further comprising:
a semiconductor substrate corresponding to a fourth step of the staircase structure, the semiconductor substrate located below the third step of the staircase structure, wherein an extent of the fourth step extends beyond the extent of the third step with respect to the x-direction.

Example 15: The apparatus of example 13 or 14, wherein a height of the second step of the staircase structure is greater than a height of the third step of the staircase structure.

Example 16: The apparatus of any of examples 13 to 15, wherein the first material comprises silver, the second material comprises nickel, and the third material comprises titanium.

Example 17: A product formed by a method, comprising:
forming a stack of materials on a semiconductor substrate, the stack of materials comprising a first material, a second material, and a third material;
performing a first etching operation, wherein the first etching operation removes a first portion of the first material;
performing a second etching operation, wherein the second etching operation removes a first portion of the second material;
performing a third etching operation, wherein the third etching operation removes a first portion of the third material;
performing a fourth etching operation, wherein the fourth etching operation removes a second portion of the second material; and
performing a fifth etching operation, wherein the fifth etching operation removes a second portion of the first material.

Example 18: The apparatus of example 17, further comprising:
forming a fourth material on a surface of the first material, wherein a position of the fourth material is static for a duration of the first etching operation, the second etching operation, the third etching operation, the fourth etching operation, and the fifth etching operation.

Example 19: The apparatus of example 17 or 18, wherein removing the first portion of the first material exposes a portion of a bottom surface of a fourth material comprising a photoresist layer, the portion of the bottom surface of the fourth material corresponding to an overhung region of the fourth material.

Example 20: The apparatus of any of examples 17 to 19, wherein removing the first portion of the second material exposes a portion of a bottom surface of the first material, the portion of the bottom surface of the first material corresponding to an overhung region of the first material.

While this detailed description has set forth some embodiments of the present invention, the appended claims also cover other embodiments of the present invention which may differ from the described embodiments according to various modifications and improvements.

## Claims

1. A method comprising:
forming a stack of materials on a semiconductor substrate, the stack of materials comprising a first material, a second material, and a third material;
performing a first etching operation, wherein the first etching operation removes a first portion of the first material;
performing a second etching operation, wherein the second etching operation removes a first portion of the second material;
performing a third etching operation, wherein the third etching operation removes a first portion of the third material;
performing a fourth etching operation, wherein the fourth etching operation removes a second portion of the second material; and
performing a fifth etching operation, wherein the fifth etching operation removes a second portion of the first material.

2. The method of claim 1, further comprising:
forming a fourth material on a surface of the first material, wherein a position of the fourth material is static for a duration of the first etching operation, the second etching operation, the third etching operation, the fourth etching operation, and the fifth etching operation.

3. The method of claim 1 or 2, wherein removing the first portion of the first material exposes a portion of a bottom surface of a fourth material comprising a photoresist layer, the portion of the bottom surface of the fourth material corresponding to an overhung region of the fourth material.

4. The method of any of claims 1 to 3, wherein removing the first portion of the second material exposes a portion of a bottom surface of the first material, the portion of the bottom surface of the first material corresponding to an overhung region of the first material.

5. The method of claim 4, wherein removing the second portion of the first material comprises removing at least the overhung region of the first material.

6. The method of any of claims 1 to 5, wherein removing the first portion of the third material exposes a portion of a bottom surface of the second material, the portion of the bottom surface of the second material corresponding to an overhung region of the second material.

7. The method of claim 6, wherein removing the second portion of the second material comprises removing at least the overhung region of the second material.

8. The method of any of claims 1 to 7, wherein removing the first portion of the first material, the first portion of the second material, and the first portion of the third material forms an inverted staircase structure in the stack of materials.

9. The method of any of claim 1 to 8, wherein removing the second portion of the second material and removing the second portion of the first material forms a staircase structure in the stack of materials.

10. The method of any of claims 1 to 9, further comprising:
performing a rinsing operation subsequent to the first etching operation, the second etching operation, the third etching operation, the fourth etching operation, and the fifth etching operation.

11. The method of any of claims 1 to 10, wherein each of the first etching operation, the second etching operation, the third etching operation, the fourth etching operation, and the fifth etching operation comprise an isotropic etching operation.

12. An apparatus comprising:
a first material of a stack of materials, the first material corresponding to a first step of a staircase structure formed using an isotropic etching operation, wherein a surface of the first step is parallel to an x-direction and a z-direction, and wherein a height of the first step is parallel to a y-direction;
a second material of the stack of materials, the second material corresponding to a second step of the staircase structure, the second step of the staircase structure located below the first step of the staircase structure with respect to the y-direction, wherein an extent of the second step extends beyond an extent of the first step with respect to the x-direction; and
a third material of the stack of materials, the third material corresponding to a third step of the staircase structure, the third step of the staircase structure located below the second step of the staircase structure with respect to the y-direction, wherein an extent of the third step extends beyond the extent of the second step with respect to the x-direction.

13. The apparatus of claim 12, further comprising:
a semiconductor substrate corresponding to a fourth step of the staircase structure, the semiconductor substrate located below the third step of the staircase structure, wherein an extent of the fourth step extends beyond the extent of the third step with respect to the x-direction.

14. The apparatus of claim 12 or 13, wherein a height of the second step of the staircase structure is greater than a height of the third step of the staircase structure.

15. The method of any of claims 1 to 11, or the apparatus of any of claims 12 to 14, wherein the first material comprises silver, the second material comprises nickel, and the third material comprises titanium.

16. A product formed by the method of any of claims 1 to 11, 15.
